## Europäisches Patentamt

## European Patent Office

## Office européen des brevets

(19)

(11) Veröffentlichungsnummer: **0 223 163**
**B1**

(12) **EUROPÄISCHE PATENTSCHRIFT**

(45) Veröffentlichungstag der Patentschrift:
**01.06.88**

(51) Int. Cl.⁴: **G 01 R 21/04**

(21) Anmeldenummer: **86115466.4**

(22) Anmeldetag: **07.11.86**

(54) Leistungsmesssensor zum Messen von Hochfrequenzleistung.

(30) Priorität: **07.11.85  DE 3539402**

(43) Veröffentlichungstag der Anmeldung:
**27.05.87 Patentblatt 87/22**

(45) Bekanntmachung des Hinweises auf die Patenterteilung:
**01.06.88 Patentblatt 88/22**

(84) Benannte Vertragsstaaten:
**BE DE FR GB IT NL**

(56) Entgegenhaltungen:
**DE - A - 3 428 077**

(73) Patentinhaber: **Rohde & Schwarz GmbH & Co. KG,
Mühldorfstrasse 15, D-8000 München 80 (DE)**

(72) Erfinder: **Delfs, Hans, Dr. Dipl.-Phys.,
Schwalbenstrasse 86, D-8012 Ottobrunn (DE)**
Erfinder: **Betz, Tilman, Dipl.-Ing., Schlehenweg 3,
D-8038 Gröbenzell (DE)**

(74) Vertreter: **Graf, Walter, Dipl.-Ing., Sckellstrasse 1,
D-8000 München 80 (DE)**

ACTORUM AG

## Beschreibung

Die Erfindung betrifft einen Leistungsmesssensor zum Messen von Hochfrequenzleistung laut Oberbegriff des Hauptanspruches.

Ein sogenannter indirekt beheizter Mikrowellen-Leistungsmesssensor laut Oberbegriff des Hauptanspruches mit galvanisch getrennten Stromkreisen für die zu messende Hochfrequenz und den Gleichstrom des Thermoelementes ist bekannt (DE-A-34 28 077). Der Absorptionswiderstand mit seinen Kontaktanschlüssen ist dabei auf der Oberseite eines Trägers aus elektrisch isolierendem Material in Dünnfilmtechnik aufgebracht und das Thermoelement ist auf der Rückseite dieses Trägers in Form von zwei getrennten Zuleitungen aus unterschiedlichen Materialien so angebracht, dass die heisse Verbindungsstelle des Thermoelementes unterhalb des Absorptionswiderstandes und die kalte Verbindungsstelle des Thermoelementes unterhalb eines auf der Oberseite angebrachten Klötzchens aus thermisch gut leitendem Material liegt. Das hier auf der Rückseite des Isoliermaterialträgers aufgedampfte Dünnschicht-Thermoelement besitzt eine relativ geringe Stabilität, da das Volumen der dünnen Schichten des Thermoelementes sehr klein ist. Ausserdem ist die getrennte Ausbildung von Dünnschichtschaltungen auf der Oberseite und Unterseite eines Trägers in der Herstellung relativ aufwendig.

Es sind an sich auch sogenannte direkt beheizte Leistungsmesssensoren bekannt (HP Journal, September 1974, Seiten 16 bis 18), bei denen der Absorptionswiderstand in Dünnfilmtechnik auf der Isolierschicht eines Siliziumträgers ausgebildet ist und bei denen das zugehörige Thermoelement durch einen Teil des Siliziumträgers gebildet ist. Solche bekannten Sensoren besitzen jedoch den Nachteil, dass sie wegen der galvanischen Kopplung zwischen dem Hochfrequenz-Messkreis und dem Thermoelement-Messkreis nicht für niedrige Frequenzen oder sogar Gleichspannung geeignet sind. Sie können ausserdem nicht auf einfache Weise mit Gleichstrom geeicht werden. Da bei diesen bekannten Sensoren der Hochfrequenzstrom dem Absorptionswiderstand über das Silizium zugeführt wird, der Querschnitt dieser Siliziumzuleitung wegen der sonst zu grossen Wärmeableitung aber nicht beliebig gross gewählt werden kann, muss bei diesen bekannten Sensoren ein sehr hoch dotiertes Silizium verwendet werden, was wiederum den Nachteil mit sich bringt, dass die im Thermoelement erzeugbare Thermokraft relativ gering ist, das Thermoelement also relativ unempfindlich ist. Ausserdem muss bei diesen bekannten Sensoren eine relativ aufwendige Gewebestruktur für das Silizium gewählt werden.

Es ist Aufgabe der Erfindung, einen direkt beheizten Leistungsmesssensor der eingangs erwähnten Art zu schaffen, der im Aufbau und in der Herstellung sehr einfach ist und trotz grosser Empfindlichkeit in seinen Messeigenschaften sehr stabil ist.

Diese Aufgabe wird ausgehend von einem Leistungsmesssensor laut Oberbegriff des Hauptanspruches durch dessen kennzeichnende Merkmale gelöst. Vorteilhafte Weiterbildungen ergeben sich aus den Unteransprüchen.

Ein erfindungsgemässer Leistungssensor ist zum Messen von Gleichstrom bis in den Mikrowellenbereich von beispielsweise 18 GHz in gleicher Weise geeignet, er kann auf einfache Weise mit Gleichstrom geeicht werden. Da das Thermoelement durch den relativ voluminösen Steg des Siliziummaterials gebildet ist, ist der Sensor in seinen Messeigenschaften zeitlich sehr stabil und driftfrei. Da ausserdem Hochfrequenz-Stromkreis und Thermoelement-Stromkreis voneinander galvanisch getrennt sind, kann das Siliziummaterial ausschliesslich nach den gewünschten Eigenschaften für das Thermoelement ausgewählt werden. Vorzugsweise wird ein n-Typ-Siliziummaterial benutzt, das gegenüber einem p-Typ-Siliziummaterial eine grössere Thermokraft besitzt. Das Siliziummaterial ist relativ niedrig dotiert, die Dotierung soll kleiner als $5 \times 10^{14}/cm^3$ sein und es wird vorzugsweise ein Material mit einer Dotierung zwischen $10^{13}$ und $5 \times 10^{14}/cm^3$ gewählt. Als Verunreinigungsmaterial ist beispielsweise Phosphor geeignet. Die Ausbildung des Thermoelementes in dem schmalen Steg des Siliziummaterials bewirkt, dass die grösste Temperaturdifferenz in diesem schmalen Siliziumsteg konzentriert wird. Damit können allein durch entsprechende Dimensionierung der Länge und Breite dieses Steges unterschiedliche Messbereiche des Sensors eingestellt werden. Wird dieser Steg relativ breit ausgebildet, ist der Sensor entsprechend unempfindlicher, kann dafür aber kurzfristig auch grössere Leistungen aushalten, ohne dass eine Materialveränderung im Absorptionswiderstand zu befürchten ist. Wird der Steg dagegen sehr schmal ausgebildet, ist die Empfindlichkeit des Sensors entsprechend grösser, dafür ist der Sensor aber wieder empfindlicher gegen Zerstörung durch zu starke Erwärmung. In der Praxis kann je nach der geforderten Messaufgabe jeweils die hierfür geeignete Stegform gewählt werden. Ist beispielsweise für einen Sensor eine Empfindlichkeit im μW-Bereich erwünscht und soll der Sensor von Hochfrequenzleistung, die kurzfristig die Grössenordnung von 1 W erreicht, nicht bleibend verändert werden, so ist es beispielsweise zweckmässig, den Siliziumsteg so zu dimensionieren, dass sein thermischer Widerstand nicht grösser als einige 100° K pro Watt beträgt.

Die Erfindung wird im folgenden anhand schematischer Zeichnungen an einem Ausführungsbeispiel näher erläutert.

Fig. 1 zeigt in stark vergrössertem Massstab die Draufsicht auf einen erfindungsgemässen Sensor,

Fig. 2 zeigt einen Schnitt längs der Linie II-II.

Der dargestellte Sensor wird wie folgt aufgebaut:

Auf einem kleinen Siliziumplättchen 1 relativ niedriger Dotierung, beispielsweise n-Typ $10^{14}/cm^3$, wird zunächst auf der Oberseite eine Isolierschicht 2 aufgebracht, beispielsweise durch Oxidation des Siliziums oder durch Aufbringen einer Schicht aus Fremdoxyd oder Siliziumnitrid. Die Isolierschicht ist sehr dünn, beispielsweise 1 μm dick. In diese Isolierschicht werden dann im Abstand voneinander längs der Mittellinie (Schnittlinie II-II) zwei kleine Fenster 6, 8 ausgeätzt, durch Eindiffundieren bzw. Implantieren wird in dem Siliziummaterial unterhalb dieser Fenster 6, 8 jeweils eine Zone 7, 9 von relativ hoher Dotierung (z.B. $10^{19}/cm^3$) erzeugt. Anschliessend wird an diesen Stellen ein geeignetes Kontaktmaterial aufgedampft und geätzt, so dass im Bereich dieser Fenster 6, 8 ein guter Kontakt mit dem darunterliegenden Siliziummaterial entsteht.

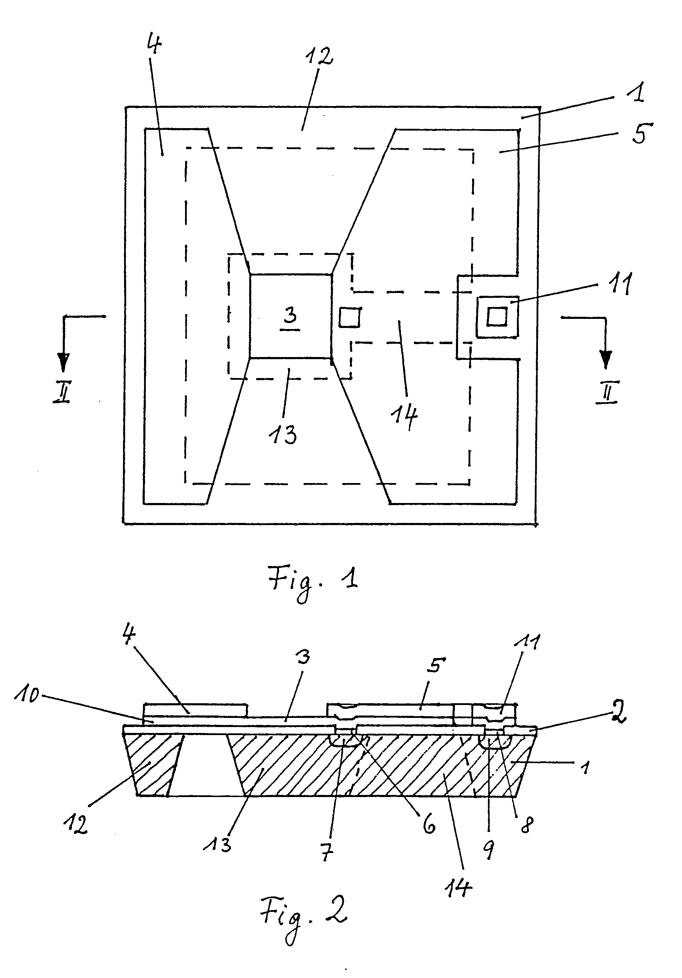

Auf die so vorbereitete Struktur wird dann eine Schicht 10 eines geeigneten Widerstandsmaterial, beispielsweise Tantalnitrid oder Chromnickel aufgedampft und darauf dann eine weitere dünne Goldschicht. Aus diesen beiden Schichten wird dann in der bekannten Dünnfilmtechnik durch Ätzen ein kleiner etwa rechteckiger Absorptionswiderstand 3 mit zugehörigen relativ grossflächigen Anschlussflächen 4 und 5 in der aus Fig. 1 ersichtlichen Form ausgeätzt, der Absorptionswiderstand 3 wird dann vorzugsweise noch mit einem Laser auf genau 50 Ohm getrimmt. Im Bereich der Kontaktstelle 8, 9 wird der breite Kontaktanschluss 5 ausgespart und dafür eine separate Kontaktfläche 11 aus der Goldschicht ausgeätzt, die nur mit dem darunterliegenden Bereich 9 des Siliziums galvanisch in Verbindung steht. Der Siliziumbereich 7 ist über das Fenster 6 mit dem darüber ausgeätzten Anschlusskontakt 5 galvanisch verbunden.

Nach dieser Vorbereitung der Oberseite wird der Siliziumträger 1 von der Rückseite aus so geätzt, dass er nur noch aus einer kleinen Insel 13 besteht, die unmittelbar unterhalb des Absorptionswiderstandes 3 vorgesehen ist und in ihrer Form etwa der Form dieses Widerstandes 3 der Oberfläche entspricht. Ausserdem ist noch ein umlaufender Rand vorgesehen, der als Wärmeableitabschnitt und als mechanisch tragender Rahmen 12 dient und der über einen schmalen Steg unterhalb der beiden Fenster 6, 7 mit der Insel 13 verbunden ist. Das übrige Siliziummaterial wird bis zur Isolierschicht 2 weggeätzt. Anschliessend kann die Oberseite noch mit einer geeigneten Schutzschicht passiviert werden. Der als Wärmeableitabschnitt wirkende Rahmen 12 wird vorzugsweise noch mit gutem Wärmekontakt auf einem Keramiksubstrat befestigt, beispielsweise über mehrere Metallkontaktstellen, die über die breiten Anschlussflächen 4, 5 verteilt sind und durch die gleichzeitig die elektrische Verbindung zu entsprechenden Anschlussfahnen auf diesem Keramiksubstrat hergestellt wird. Eine andere Möglichkeit besteht darin, die Kontaktfahnen 4, 5, 11 seitlich über den Rand des Siliziumträgers zu verbreitern und damit eine gut wärmeleitende Verbindung mit entsprechenden Kontakten eines Keramiksubstrats herzustellen.

Im Betrieb wird die HF-Quelle, deren Leistung gemessen werden soll mit den Kontaktanschlüssen 4 und 5 verbunden, der Anschluss 5 liegt beispielsweise an Masse. Durch die so dem kleinen und beispielsweise nur einige wenige Zehntel Millimeter grossen Absorptionswiderstand 3 zugeführte Hochfrequenzleistung wird dieser erwärmt, dadurch wird gleichzeitig durch die dünne Isolierschicht 2 hindurch die Siliziuminsel 13 erwärmt. Die laterale Wärmeleitung in der Isolierschicht 2 ist sehr gering, die Kontaktflächen 4 und 5 sind so dünn ausgeführt, dass sie keine nennenswerte Wärmeleitung bewirken. Die in der Siliziuminsel 13 erzeugte Wärme kann daher im wesentlichen nur über den schmalen Siliziumsteg 14 zum Siliziumrahmen 12 abfliessen und von dort dann zu dem Keramiksubstrat. An den Enden des Siliziumsteges 14 entsteht also die grösste Wärmedifferenz, durch geeignete Dimensionierung der Siliziumstruktur kann erreicht werden, dass praktisch 80% der Temperaturdifferenz in diesem Steg 14 auftritt. Diese Temperaturdifferenz erzeugt in dem als Thermoelement wirkenden Siliziumsteg 14 zwischen den Kontaktstellen 6, 7 und 8, 9 eine relativ grosse Thermospannung von beispielsweise 800 bis 900 μV pro °K, die über die Anschlüsse 5 und 11 dem Verstärker einer Anzeigeeinrichtung zugeführt wird und dort angezeigt oder anderweitig ausgewertet wird. Die erzeugte Thermospannung ist der Erwärmung des Widerstandes 3 und damit auch der aufgenommenen Hochfrequenzleistung näherungsweise proportional. Die beiden Kontaktstellen 6, 7 und 8, 9 werden vorzugsweise so gelegt, dass zwischen ihnen ein möglichst grosser Abstand besteht, die eine Kontaktstelle 6, 7 ist nahe dem Rand des Absorptionswiderstandes 3 ausgebildet, die andere Kontaktstelle 8, 9 etwa im Übergangsbereich des Steges 14 in den Rahmen 12 des Siliziums. Die Breite und Länge des schmalen Siliziumsteges wird entsprechend den gewünschten Empfindlichkeitseigenschaften des Thermoelements gewählt. Da der Hochfrequenz-Stromkreis 4, 3, 5 völlig galvanisch getrennt ist von dem Thermoelement-Messkreis 11, 8, 9, 1, 7, 6, 5 und diese beiden Stromkreise nur am Massepunkt 5 miteinander verkoppelt sind, kann der Sensor auch mit Gleichspannung auf einfache Weise geeicht werden. Die ohmschen Kontaktzonen 7, 9 werden durch bekannte höhere Dotierung des Siliziummaterials erzeugt und zwar wird hier die Dotierung grösser als $5 \times 10^{18}/cm^3$ gewählt, vorzugsweise in einem Bereich zwischen $5 \times 10^{18}/cm^3$ und $5 \times 10^{19}/cm^3$.

## Patentansprüche

1. Leistungsmesssensor zum Messen von Hochfrequenzleistung mit einem auf der Oberseite eines Trägers in Dünnfilmtechnik ausgebildeten Absorptionswiderstand (3) und mit einem von dem Stromkreis (4, 3, 5) dieses Absorptionswiderstandes galvanisch getrennt ausgebildeten Thermoelement, dadurch gekennzeichnet, dass der Träger aus Silizium besteht, der Absorptionswiderstand (3) auf einer Isolierschicht (2) dieses Siliziumträgers (1) ausgebildet ist und dieser Siliziumträger (1) eine unterhalb des Absorptionswiderstandes (3) ausgebildete Insel (13), einen im Abstand davon ausgebildeten wärmeableitenden Abschnitt und einen dazwischen vorgesehenen, die Insel (13) und den wärmeableitenden Abschnitt thermisch verbindenden, entsprechend dem zu erzielenden Messbereich dimensionierten Steg (14) umfasst, und das Thermoelement durch diesen Steg (14) sowie im Abstand voneinander an diesem Steg (14) ausgebildete Kontaktstellen (6, 7 und 8, 9) gebildet ist.

2. Sensor nach Anspruch 1, dadurch gekennzeichnet, dass die Kontaktstellen für das Thermoelement durch oberhalb des Siliziumsteges (14) in der Isolierschicht (2) ausgebildete Fenster (6, 8) und darunter im Siliziumsteg (14) ausgebildete Zonen (7, 9) höherer Dotierung gebildet sind und diese Zonen (7, 9) mit auf der dem Absorptionswiderstand (3) zugewandten Seite der Isolierschicht (2) ausgebildete Anschlusskontakte (5, 11), galvanisch verbunden sind.

3. Sensor nach Anspruch 1 oder 2, dadurch gekennzeichnet, dass der wärmeableitende Abschnitt des Siliziumträgers durch einen die Insel (13) umgebenden Rahmen (12) gebildet ist.

4. Sensor nach einem der vorhergehenden Ansprüche, dadurch gekennzeichnet, dass die eine Kontaktstelle (6, 7) des Thermoelementes am Rand der Insel (13) und die andere Kontaktstelle (8, 9) am Übergang zwischen Steg (14) und wärmeableitendem Abschnitt ausgebildet ist.

5. Sensor nach einem der vorhergehenden Ansprüche, dadurch gekennzeichnet, dass der wärmeableitende Abschnitt des Siliziumträgers auf einem Keramiksubstrat befestigt ist.

6. Sensor nach einem der vorhergehenden Ansprüche, dadurch gekennzeichnet, dass der Siliziumträger (1) aus n-Typ-Silizium mit einer Dotierung kleiner als $5 \times 10^{14}/cm^3$ besteht.

## Revendications

1. Capteur de mesure de puissance pour mesurer une puissance de haute fréquence comportant une résistance par absorption (3) réalisée sur la face supérieure d'un support selon la technique des films minces et un thermocouple galvaniquement séparé du circuit électrique (4, 3, 5) de cette résistance par absorption, caractérisé en ce que le support est en silicium, la résistance par absorption (3) étant réalisée sur une couche isolante (2) de ce support en silicium, et ce support en silicium (1) comporte un îlot (13) réalisé sous la résistance par absorption (3), un segment d'évacuation de chaleur à une certaine distance de cet îlot et une entretoise (14) dans l'intervalle, cette entretoise réalisée en fonction de la plage de mesure à obtenir reliant, de manière thermique, l'îlot (13) et le segment d'évacuation de chaleur, et le thermocouple est formé par cette entretoise (14) ainsi que des points de contact (6, 7 et 8, 9) distants l'un de l'autre sur cette entretoise (14).

2. Capteur selon la revendication 1, caractérisé en ce que les points de contact du thermocouple sont constitués par des fenêtres (6, 8) réalisées dans la couche isolante (2) au-dessus de l'entretoise en silicium (14) et par des zones (7, 9) réalisées sous l'entretoise en silicium (14) et ayant un plus fort dopage, ces zones (7, 9) étant reliées galvaniquement aux points de raccordement (5, 6) réalisés sur le côté de la couche d'isolation (2) tourné vers la résistance par absorption (3).

3. Capteur selon la revendication 1 ou 2, caractérisé en ce que le segment d'évacuation de chaleur du support de silicium est formé par un cadre (12) entourant l'îlot (13).

4. Capteur selon l'une des revendications précédentes, caractérisé en ce que l'un des points de contact (6, 7) du thermocouple est réalisé au bord de l'îlot (13) et l'autre point de contact (8, 9) est réalisé à la transition entre l'entretoise (14) et le segment d'évacuation de chaleur.

5. Capteur selon l'une des revendications précédentes, caractérisé en ce que le segment d'évacuation de chaleur du support en silicium est fixé sur un support en céramique.

6. Capteur selon l'une des revendications précédentes, caractérisé en ce que le support en silicium (1) est un silicium de type n ayant un dopage inférieur à $5 \times 10^{14}/cm^3$.

## Claims

1. Power measuring sensor for measuring highfrequency power comprising a thin-film power absorbing resistor (3) formed on the top surface of a support and a thermocouple electrically isolated from the circuit (4, 3, 5) of said absorbing resistor, characterized in that the support consists of silicon, the absorbing resistor (3) is formed on an insulating film (2) of said silicon support (1) and said silicon support (1) comprises an island (13) formed beneath said absorbing resistor (3), a heat sink portion formed in spaced relationship to said island and a narrow bridge (14) provided inbetween thermally connecting the island (13) and the heat sink portion and dimensioned according to the desired measurement range, and in that the thermocouple is formed by said bridge (14) and by contact zones (6, 7 and 8, 9) provided on said bridge (14) in spaced relation.

2. Sensor according to claim 1, characterized in that the contact zones of said thermocouple are formed by windows (6, 8) provided in said insulating film (2) above said silicon bridge (14) and by more heavily doped zones (7, 9) provided therebeneath in said silicon bridge (14) said zones (7, 9) being conductively connected to terminal contacts (5, 11) formed on the surface of said insulating film (2) facing the absorbing resistor (3).

3. Sensor according to claim 1 or claim 2, characterized in that the heat sink portion of said silicon support is formed by a frame (12) surrounding said island (13).

4. Sensor as claimed in any of the preceding claims, characterized in that the one contact zone (6, 7) of the thermocouple is formed on the edge of the island (13) and the other contact zone (8, 9) is formed at the transition between bridge (14) and heat sink portion.

5. Sensor as claimed in any of the preceding claims, characterized in that the heat sink portion of the silicon support is bonded to a ceramic substrate.

6. Sensor as claimed in any of the preceding claims, characterized in that the silicon support (1) consists of n-type silicon with a doping concentration of less than $5 \times 10^{14}/cm^3$.

Fig. 1

Fig. 2

7